**Europäisches Patentamt**

**European Patent Office**

**Office européen des brevets**

(11) Publication number: **0 118 237**

**B1**

(12) # EUROPEAN PATENT SPECIFICATION

(45) Date of publication of patent specification: **19.04.89**

(51) Int. Cl.⁴: **H 01 L 23/48**

(21) Application number: **84300842.6**

(22) Date of filing: **10.02.84**

(54) **Lead frame for a semiconductor element.**

(30) Priority: **12.02.83 JP 20549/83**

(43) Date of publication of application:
**12.09.84 Bulletin 84/37**

(45) Publication of the grant of the patent:
**19.04.89 Bulletin 89/16**

(84) Designated Contracting States:
**DE FR GB**

(56) References cited:
**FR-A-2 118 154**
**FR-A-2 216 750**
**US-A-3 791 025**

**PATENTS ABSTRACTS OF JAPAN, vol. 6, no. 132 (E-119)1010r, 17th July 1982; & JP-A-57-58 344**

(73) Proprietor: **FUJITSU LIMITED**
**1015, Kamikodanaka Nakahara-ku**
**Kawasaki-shi Kanagawa 211 (JP)**

(72) Inventor: **Ono, Michio c/o Fujitsu Limited**
**Patent Department 1015 Kamikodanaka**
**Nakahara-ku Kawasaki-shi Kanagawa 211 (JP)**
Inventor: **Kubota, Akihiro c/o Fujitsu Limited**
**Patent Department 1015 Kamikodanaka**
**Nakahara-ku Kawasaki-shi Kanagawa 211 (JP)**
Inventor: **Inoue, Osamu c/o Fujitsu Limited**
**Patent Department 1015 Kamikodanaka**
**Nakahara-ku Kawasaki-shi Kanagawa 211 (JP)**
Inventor: **Sugiura, Rikio c/o Fujitsu Limited**
**Patent Department 1015 Kamikodanaka**
**Nakahara-ku Kawasaki-shi Kanagawa 211 (JP)**
Inventor: **Aoki, Tsuyoshi c/o Fujitsu Limited**
**Patent Department 1015 Kamikodanaka**
**Nakahara-ku Kawasaki-shi Kanagawa 211 (JP)**

(74) Representative: **Sunderland, James Harry et al**
**HASELTINE LAKE & CO Hazlitt House 28**
**Southampton Buildings Chancery Lane**
**London WC2A 1AT (GB)**

Courier Press, Leamington Spa, England.

## Description

The present invention relates to a lead frame for a semiconductor element, for example for an integrated circuit (IC) with a molded type IC package.

A lead frame for an IC has a stage, for mounting an IC die or chip (called a chip hereinafter), and lead pins, for wiring to the chip, for connecting the IC to external circuits. FR-A- 2 118 154 discloses a lead frame with a stage, leads disposed around the stage, and an outer frame supporting the leads.

Lead frames are made for example by being punched out from a metal ribbon or a roll of metal sheet, and many lead frames are formed from one ribbon or roll initially all joined together in a continuous line or queue. When so formed the stage and lead pins of each lead frame are fixed in position by stage bars and tie bars respectively, and fixed to an outer frame.

An IC chip is mounted on the stage of a lead frame and bonding pads on the chip are connected electrically by bonding wires to tips of corresponding lead pins.

For packaging, the chip is then encased in molded plastics material, and separated by cutting the lead pins off from the tie bars and from the outer frame. Lead pins projecting from a molded case are then bent or shaped, to complete a molded type packaged IC.

Portions of lead pins encapsulated in the molded case are called inner leads, and portions which protrude out of the molded case are called outer leads.

IC packages are being required to hold larger and more complex chips, without changes to or enlargements of the standard sizes or forms of the packages, in order to provide increased packing density.

For a packaged IC, the ratio of stage or chip area to the total (plan) area of the IC package is taken as an index of packing density, called packing density factor hereinafter.

In order to increase the packing density factor it is necessary to reduce the area which is taken up by inner leads.

For reasons explained below, however, the width of inner leads cannot be made too narrow. Moreover, the bonding pads of IC chips tend to be arranged along only two opposite sides of the chip, whereas outer leads are generally required to be positioned only on two sides of the chip package which are perpendicular to the above-mentioned sides of the chip. Thus, the inner leads have to be bent and take complicated shapes.

These requirements have limited the packing density factor as defined above, even though the packing density of elements in an IC chip has increased. This problem of packing density is now becoming a serious problem.

According to the present invention there is provided a lead frame, for mounting a semiconductor element, having a stage for mounting the semiconductor element, leads disposed around the stage, and an outer frame supporting the leads, wherein at least one of the leads has a part between the outer frame and the stage, extending along an edge of the stage, of a reduced width as compared with other lead parts, and the lead frame has a supporting bar establishing a supporting connection to the outer frame for the reduced-width lead part.

An embodiment of the present invention can provide a lead frame affording an improved packing density factor.

An embodiment of the present invention can provide a lead frame such that the width of inner leads is as fine as possible, so that packing density factor can be increased. It is applicable for example to a plastic chip carrier or the like.

An embodiment of the present invention can also provide a packaged semiconductor device, a packaged IC or other semiconductor element, having an improved packing density factor. That is, a packaged semiconductor device can be provided whose shape is not altered from that of known packaged IC's but which carries a larger chip. Alternatively, a packaged IC can be provided with a previously used chip but mounted in a smaller package.

An embodiment of the present invention can also provide a method of fabricating such packaged devices, without cost increase, by using such lead frames.

Briefly, a lead frame embodying the present invention has inner leads of a particular pattern. This pattern is characterized in that portions of inner leads between the stage of the lead frame and its outer frame in parallel to an edge of the stage have an extremely low width, which is at or near the minimum size workable by punching technology.

By apply such a pattern, inner leads become too slender of themselves for safe handling in bonding and molding processes. To overcome this problem, inner leads are bridged to the outer frame with supporting bars. Thus, inner leads are kept in position and free from deformation during assembly of a packaged semiconductor device using the lead frame. Such bridges are cut away together with the outer frame, after a molding process.

Using such a lead frame, it is possible to mount a larger chip in a packaged semiconductor device without change in shape or increase in size of the packaged device. Alternatively, a packaged semiconductor device mounting a chip of given size can be made smaller.

Reference is made, by way of example, to the accompanying drawings, in which:

Fig. 1 is a plan view, to an enlarged scale, of a previous lead frame for an IC;

Fig. 2 is a plan view, to a larger scale than Fig. 1, of part of the lead frame of Fig. 1;

Fig. 3 is a plan view, to an enlarged scale, of a lead frame in accordance with an embodiment of the present invention;

Fig. 4 is a plan view, to an enlarged scale, of another lead frame, in accordance with another embodiment of the present invention;

Fig. 5 illustrates an IC, at a production stage just after mold sealing, using a lead frame as shown in Fig 4. and

Fig. 6 illustrates an IC using a lead frame as shown in Fig. 4, after formation of outer leads; in Fig. 6, (a) is a top view of the IC; (b) is a side view of the IC; and (c) is a bottom view of the IC.

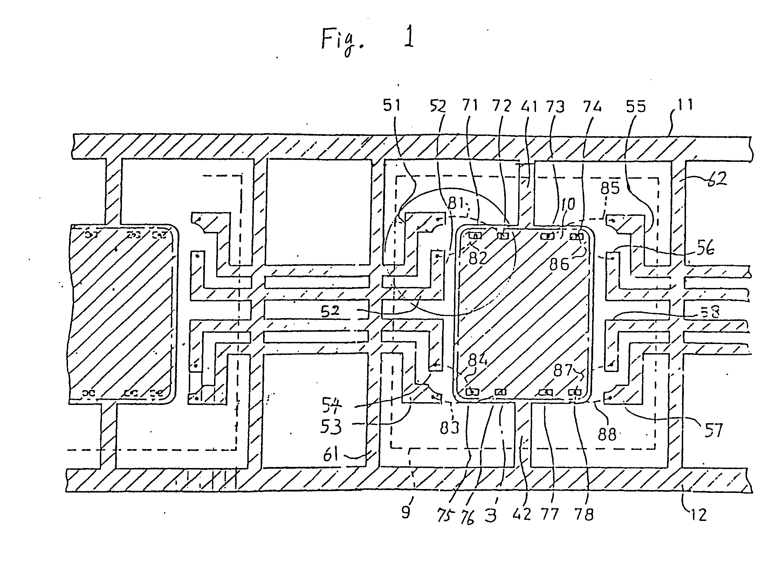

Fig. 1 shows the pattern of a previous lead frame. In Fig. 1, one complete lead frame pattern is seen together with a part of an adjacent pattern of a similar lead frame. In Fig. 1, 11 and 12 are lateral bars and 61 and 62 are tie bars which connect the lateral bars. Together, bars 11, 12, 61 and 62 form an outer frame. 3 is a stage on which an IC chip is to be mounted. 41 and 42 are stage bars, connected to stage 3 and respectively to lateral bars 11 and 12, which keep stage 3 in position in the frame. 51 to 58 are leads. Leads 51 to 54 are connected together by the bar 61. Leads 55 to 58 are connected by tie bar 62. By these connections the leads 51 to 58 are kept in position relative to the stage and outer frame.

Portions of the leads which are eventually sealed or molded in an IC package, (which portions lie within the broken line rectangle 9 in Fig. 1) are called inner leads. Portions which will lie outside the molded package are called outer leads.

Lead frames as shown in Fig. 1 are produced connected side by side to one another in a continuous train or queue, as generally indicated in Fig. 1, and are fabricated by punching or etching from a metallic ribbon of nickel-iron alloy or copper alloy.

An IC chip 10, indicated by a chain line in Fig. 1, is mounted on the stage 3, and bonding pads 71 to 78 which are fabricated on the chip surface are wire bonded by bonding wires 81 to 88 to the tips of respective inner leads of the lead frame. Bonding wires 81 to 88 are for example made of gold or aluminium.

Then, the IC chip is sealed in plastics material by molding.

The tie bars 61 and 62, and stage bars 41 and 42 are then cut away from lateral bars 11 and 12. At the same time, outer leads, up to now linked to one another by tie bars, are separated and are bent into desired shapes. Thus, a molded type packaged IC is formed.

In order to make bonding easy, tips of inner leads should be as close as possible to respective bonding pads of an IC chip to be mounted on the lead frame. However, the bonding pads on an IC chip may be arranged on the shorter edges of the chip, as a consequence of chip design. This means that the bonding pads are located on the edges of a chip parallel to the lateral bars 11 and 12, in the case of a lead frame as shown in Fig. 1. On the other hand, the outer leads are often required to be positioned along lines perpendicular to the lines of the bonding pads. This means that the inner leads of the lead frame must take a complicated shape.

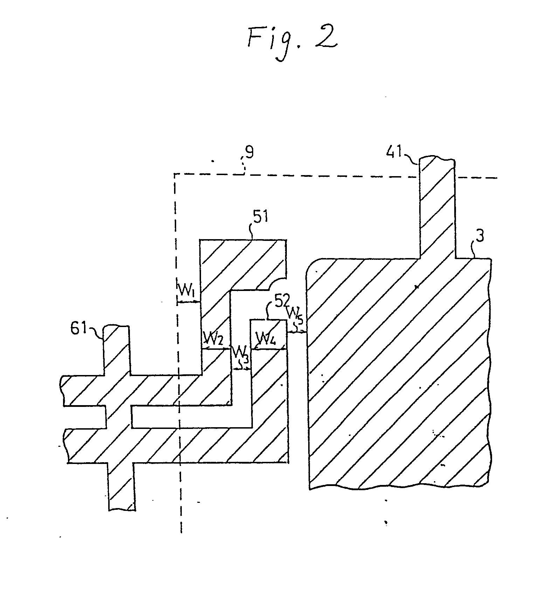

For example, inner leads are often formed with crank shape, as seen in the case of inner leads 51, 53, 55 and 57 of Fig. 1. Alternatively, they have an L shape as seen for inner leads 52, 54, 56 and 58. The width of and the spacing between the inner leads cannot be made too narrow, for reasons described below with reference to Fig. 2.

It has thus proved difficult to improve the packing density factor on the basis of lead frames as shown in Fig. 1.

Fig. 2 shows to a larger scale the part of Fig. 1 ringed by a circle. In Fig. 2, $W_1$ is a distance parallel to lateral bars 11 and 12 between a side of broken-line rectangle 9, corresponding to an edge of a molded package casing, and a part of inner lead 51 which is perpendicular to the lateral bars and located alongside the stage 3. $W_2$, $W_3$, $W_4$ and $W_5$ are, respectively, width of inner lead 51, spacing between inner leads 51 and 52, width of inner lead 52 and spacing between the inner lead 52 and the stage 3, all parallel to lateral bars 11 and 12.

It is necessary to reduce the sum $W_1+W_2+W_3+W_4+W_5$ as much as possible in order to improve the packing density factor.

However, each distance W has a lower limit, as follows:

(1) $W_1$ must be sufficiently large to maintain electrical insulation and to afford strength to resist a pulling force applied to the leads;

(2) $W_2$ is required to be sufficiently large that the inner lead has adequate strength to resist deformation in the wire bonding or molding process;

(3) $W_4$ must be large enough to provide a specific width required for wire bonding; and

(4) minimum values of $W_3$ and $W_5$ are determined by the limits of punching technology and by the thickness of the lead frame.

Embodiments of the present invention are intended to provide for an improvement regarding lower limit (2), by connecting inner leads to tie bars by means of support bars, thereby to allow the width of inner leads to reduced to the limit permitted by lead frame fabrication technology.

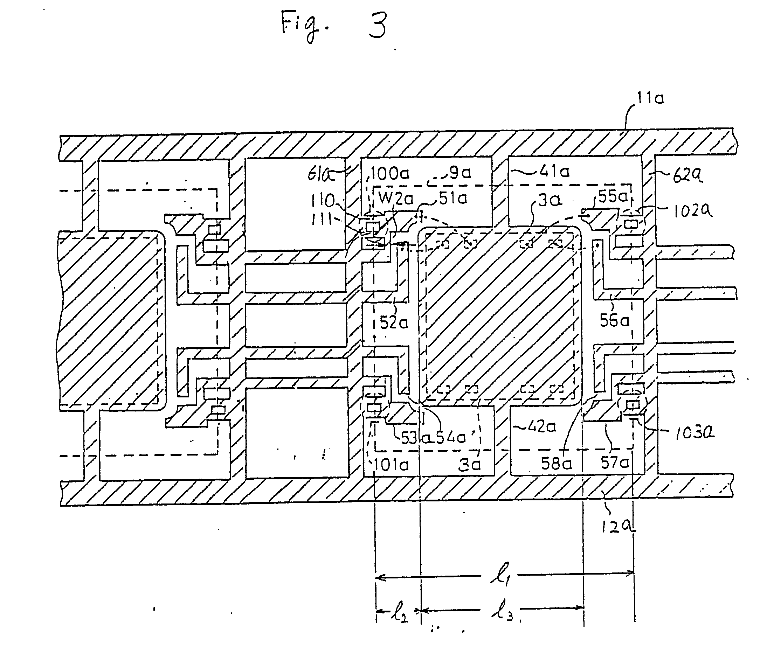

Fig. 3 shows a lead frame pattern according to an embodiment of the present invention. In Fig. 3, 11a and 12a are lateral bars, 3a is a stage, 41a and 42a are stage bars, 51a to 58a are inner leads, and 61a and 62a are tie bars, i.e. parts of an outer frame, for supporting the inner leads in position. The parts of the lead frame of Fig. 3 mentioned above are substantially similar to those parts designated by similar reference numerals (without suffix "a") in Fig. 1.

Additionally, in the lead frame of Fig. 3, there are provided supporting bars 100a, 101a, 102a and 103a, between tips of crank shaped inner leads 51a, 53a, 55a or 57a, and the tie bars 61a or 62a, as shown in the small broken-line circles in Fig. 3. For example, supporting bar 100a, placed between the tip of inner lead 51a and tie bar 61a, comprises two bridges 110 and 111 which fix the tip of inner lead 51a to tie bar 61a. A hole or hollow portion is left between the two bridges. Thus, it appears as if the inner lead 51a has branches 110 and 111. The supporting bars 101a, 102a and 103a are similarly formed.

Whilst a chip or other semiconductor element is being mounted on the stage 3a, during wire bonding to specific inner leads, and until the molding of a casing, using appropriate plastic material, the tips of inner leads 51a, 53a, 55a and 57a are fixed firmly to respective tie bars 61a and 62a by supporting bars 100a, 101a, 102a and 103a respectively. Thus, it is possible to reduce the width W2a of the inner lead 51a at its portion parallel to the tie bar 61a, to the smallest width which can be obtained using punching technology. In the same way, the widths of similar portions of the inner leads 53a, 55a and 57a can be reduced.

So, as shown in Fig. 3, if $1_1$, the width of the eventual molded package casing is equal to that of the package casing of Fig. 1 (that is, with the same casing size) it is possible to make $1_2$, the distance between the stage 3a and the edge of the casing, smaller than is possible for the frame of Fig. 1. Therefore $1_3$, the width of the stage 3a, can be made wider, and a larger chip can be mounted on the stage. On the other hand, for the same chip size, $1_1$ can be made smaller, that is, package size can be reduced.

Thus, packing density factor can be improved. In practice, using such a pattern of lead frame as is shown in Fig. 3, the packing density factor can be improved by 20-30% as compared with a lead frame pattern as shown in Fig. 1.

In order to complete the packaged IC, the molded device is cut away from the outer frame, at the same time the outer leads are separated from each other, and the tips of the outer leads, up to now supported by supporting bars, are cut away from respective supporting bars. Though they are now cut away from the supporting bars, the inner leads are fixed in molded casing and there is no likelihood of deformation. The branch portions of inner leads, for example bridges 110 and 111 in Fig. 3, are left in the molded casing and provide reinforcement to help keep the tips of the inner leads in position. Though the tips of the branch portions project out slightly from the molded case, this has no effect either upon sealing or upon the characteristics of the IC.

The outer leads are then bent into a specified shape, in a process exactly the same as for Fig. 1. There is no need to change the process used for assembling the packaged IC. Therefore, the cost of production is no greater.

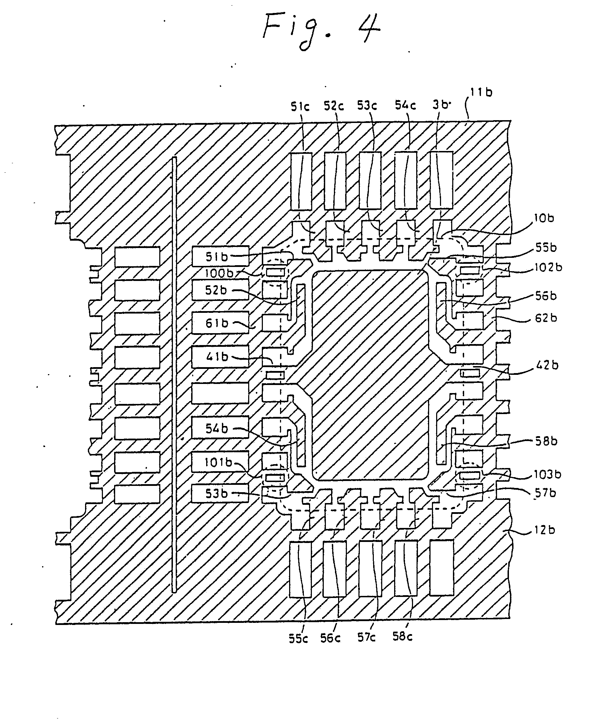

Fig. 4 is a plan view of another type of lead frame according to an embodiment of the present invention.

In Fig. 4, stage 3b is supported by stage bars 41b and 42b, which are not directly connected to lateral bars 11b and 12b (compare Fig. 3). The stage bars are fixed to tie bars 61b and 62b. These tie bars are fixed to lateral bars 11b and 12b.

The lead frame of Fig. 4 differs from that of Fig. 3 in that additional leads 51c to 58c are provided in Fig. 4 directly extending from lateral bars 11b and 12b. The additional leads are linked to each other by additional tie bars, and their presence makes it possible to provide more connections for (for connecting to bonding pads of) larger or more complicated IC chip circuits.

The embodiment of Fig. 4 also differs from that of Fig. 3 in that stage bars 41b and 42b are each made up of two bridges similarly to the supporting bars 100b to 103b. It is desirable to minimise stage bar width in order to prevent moisture affecting the IC chip mounted on the stage 3b. Since the stage bars are connected directly to the chip, unlike other leads which are connected to the chip via bonding wire, moisture may penetrate to the chip along the surface of the metal frame along the stage bar. It is thus preferable to make stage bar cross section as small as possible.

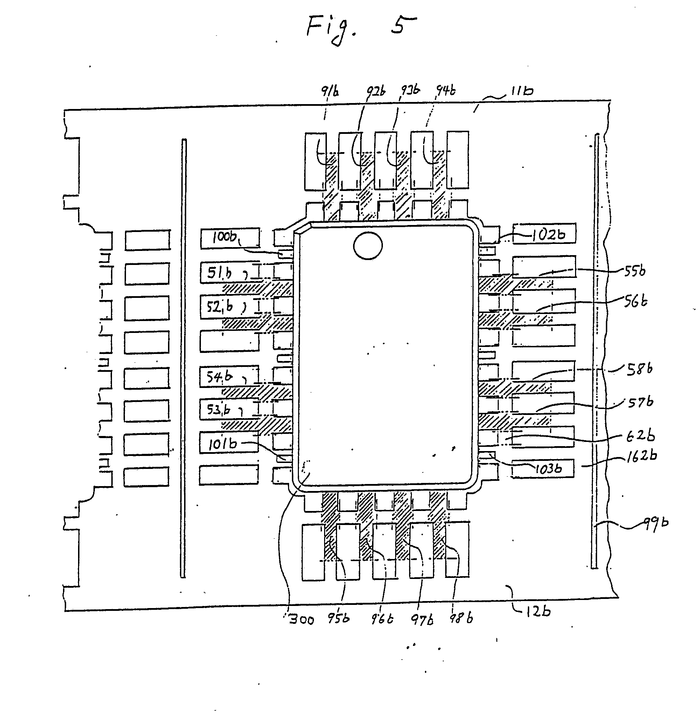

Fig. 5 shows the appearance of a device just after a molding process for forming a molded package casing around a chip is finished. In the case of Fig. 5, the lead frame used is as shown in Fig. 4. A chip is mounted on the stage 3b and (its bonding pads) wire bonded to respective inner leads, then the stage 3b is sealed in plastics material. Fig. 5 illustrates the leads projecting out from plastic body or casing 300 in which the chip is sealed.

Following the molding process, outer leads are formed by cutting off tie bars and supporting bars. Cutting of these bars is effected along the double-dot chain lines in Fig. 5, so that the portions hatched in the Figure remain in place. These hatched portions 51b to 58b and 91b to 98b constitute the outer leads, which are bent and formed as required for the IC concerned.

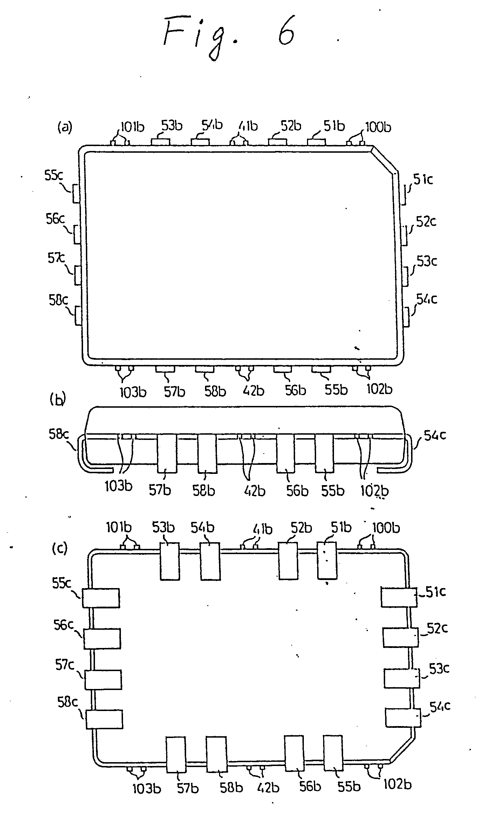

Fig. 6 shows external appearance of a finished, packaged IC using a lead frame as shown in Fig. 4. Fig. 6 (a) is a top plan view, Fig. 6 (b) is a side view, and Fig. 6 (c) is a bottom plan view of the packaged IC. As shown, the outer leads are bent inwardly beneath the molded casing, and easy to solder to external circuits. This form of IC package is convenient for use with spring connectors. This type of IC package is called a plastic chip carrier, and is used widely for small size circuits.

As shown in Fig. 6, the tips of the branch portions that form parts of supporting bars which remain within the molded casing, can be seen from the outside of the casing, because it is difficult to cut the supporting bars exactly at the surface of the casing. However, as mentioned before, this does not affect either the sealing or the characteristics of IC.

As described above, the packing density factor of IC devices can be increased by applying embodiments · of the present invention. The improvement in packing density factor may be 20 to 30%, and this is very significant having regard to recent developments of miniature circuits, which are required to be small as possible. It will be understood that this improvement in packing density factor can represent either a 20%-30% increase in the size of chips which can be accommodated in an area of given size, which means that a large number of elements can be added to each chip, or a 20% to 30% increase in the number of chips of a given size which can be accommodated in an area of given size.

Embodiments of the present invention do not require any special modifications or special processes for producing packaged devices. Thus, conventional processes and devices can be used for the production of ICs embodying the present invention. Therefore, cost increases are avoided.

The above description has been given with respect to so-called plastic chip carried type packaged IC's. However, it will be clear that the embodiments of the invention can be applied to any other type of packaged IC and not only to IC's but also to any other kind of semiconductor element.

An embodiment of the present invention can provide a lead frame for mounting a semiconductor chip or other semiconductor element, which offers improved packing density, for example for a plastic chip carrier type 5 packaged IC. Parts of inner leads located parallel to the stage and the edge of a molded casing of the package, are made as thin as possible. They are fixed to tie bars, until a molding process is finished, by inner lead supporting bars. After the molding process is finished, bars supporting the leads and the stage are cut away. Packing density factor can be improved by about 20-30%.

## Claims

1. A lead frame, for mounting a semiconductor element, having a stage (3a; 3b) for mounting the semiconductor element, leads (51a to 57a; 51b to 58c) disposed around the stage (3a; 3b), and an outer frame (11a, 12a, 61a, 62a; 11b, 12b, 61b, 62b) supporting the leads, wherein at least one of the leads (51a, 53a, 55a, 57a; 51b, 53b, 55b, 57b) has a part between the outer frame and the stage (3a; 3b), extending along an edge of the stage, of a reduced width as compared with other lead parts, and the lead frame has a supporting bar (100a, 101a, 102a, 103a; 100b, 101b, 102b, 103b) establishing a supporting connection to the outer frame for the reduced-width lead part.

2. A lead frame as claimed in claim 1, wherein the reduced-width lead part has a width substantially as small as it is possible to provide with the technology by which the lead frame is fabricated.

3. A lead frame as claimed in claim 1 or 2, formed by punching metal, for example copper alloy or nickel-iron alloy, wherein the reduced-width lead part has a width substantially as small as it is possible to provide by metal punching.

4. A lead frame as claimed in claim 1, 2 or 3, wherein each lead of a plurality (51a, 52a; 53a, 54a; 55a, 56a; 57a, 58a; 51b, 52b; 53b, 54b; 55b, 56b; 57b, 58b) has, between the outer frame (11a, 12a, 61a, 62a; 11b, 12b, 61b, 62b) and the stage (3a, 3b), a part extending in parallel to an edge of the stage, such that those edge-parallel parts are arranged alongside one another between the outer frame and the stage, the said reduced-width lead part being that one of those edge-parallel parts nearest the outer frame.

5. A lead frame as claimed in claim 1, 2, 3 or 4, wherein more than one of the leads (51a, 53a, 55a, 57a; 51b, 53b, 55b, 57b) has such a reduced-width lead part, with respective supporting bars (100a, 101a, 102a, 103a; 100b, 101b, 102b, 103b) establishing supporting connections to the outer frame (11a, 12a, 61a, 62a; 11b, 12b, 61b, 62b) for those parts.

6. A lead frame as claimed in claim 5, when read as appended to claim 4, wherein there are four such pluralities of leads (51a, 52a; 53a, 54a; 55a, 56a; 57a, 58a; 51b, 52b; 53b, 54b; 55b, 56b; 57b, 58b), one lead (51a; 53a; 55a; 57a; 51b; 53b; 55b; 57b) in each plurality having such a reduced-width part, the edge-parallel parts of the leads of respective different pluralities either lying between different edges of the stage (3a; 3b) and the outer frame (11a, 12a, 61a, 62a; 11b, 12b, 61b, 62b), or extending in opposite directions along the same edge of the stage.

7. A lead frame as claimed in claim 5, wherein the stage is rectangular, with the four pluralities of leads (51b, 52b; 53b, 54b; 55b, 56b; 57b, 58b) disposed to two opposite sides of the stage (3b), with additional leads (51c to 58c) disposed to the other two opposite sides of the stage.

8. A lead frame as claimed in any preceding claim, wherein the or each supporting bar (100a, 101a, 102a, 103a; 100b, 101b, 102b, 103b) extends perpendicularly to the reduced-width lead part for which it establishes a supporting connection to the outer frame.

9. A lead frame as claimed in any preceding claim, wherein the or each supporting bar (100a, 101a, 102a, 103a; 100b, 101b; 102b, 103b) is constituted by two branches or bridges linking the relevant reduced-width lead part to the outer frame, with a gap between the two branches or bridges.

10. A lead frame as claimed in any preceding claim, wherein the outer frame comprises lateral bars (11a, 12a; 11b, 12b) and tie bars (61a, 62a; 61b, 62b), a stage bar (41a, 42a; 41b, 42b) being provided to connect the stage (3a; 3b) to the outer frame, and respective groups of the leads being connected together by respective tie bars.

11. A lead frame as claimed in claim 10, wherein the outer frame has two lateral bars (11a, 12a; 11b, 12b) and two tie bars (61a, 62a; 61b, 62b), forming a rectangular frame, and the stage bar (41a, 42a; 41b, 42b) is connected either to the tie bars or to the lateral bars.

12. A lead frame as claimed in claim 10 or 11, wherein a part of the stage bar (41a, 42a; 41b, 42b) neighbouring the stage is constituted by two branches or bridges with a gap therebetween.

13. A packaged semiconductor device, comprising a lead frame as claimed in any preceding claim, a semiconductor element mounted on the stage, and a casing encapsulating the element, the stage and portions of the leads, the or each said reduced-width lead part and part of the length of the corresponding supporting bar being encapsulated within the casing.

## Patentansprüche

1. Leitungsrahmen zur Montage eines Halbleiterelements, mit einer Bühne (3a; 3b) zur Montage des Halbleiterelements, Leitungen (51a bis 57a; 51b bis 58c), die um die Bühne (3a; 3b) angeordnet sind, und einem äußeren Rahmen (11a, 12a, 61a, 62a; 11b, 12b, 61b, 62b), der die Leitungen trägt, wobei wenigstens eine der Leitungen (51a, 53a, 55a, 57a; 51b, 53b, 55b, 57b) zwischen dem äußeren Rahmen und der Bühne (3a; 3b) einen Abschnitt, der sich längs einem Rand der Bühne erstreckt, von reduzierter Breite im Vergleich mit anderen Leitungsabschnitten hat, und der Leitungsrahmen eine Tragstange (100a, 101a, 102a, 103a; 100b, 101b, 102b, 103b) hat, die für den Leitungsabschnitt mit reduzierter Breite eine Tragverbindung zu dem äußeren Rahmen hat.

2. Leitungsrahmen nach Anspruch 1, bei dem der Leitungsabschnitt mit reduzierter Breite eine Breite hat, die im wesentlichen so klein wie möglich ist, um mit der Technologie, durch die dieser Leitungsrahmen hergestellt wird, hergestellt werden kann.

3. Leitungsrahmen nach Anspruch 1 oder 2, gebildet durch Stanzen von Metall, z.B. Kupferlegierung oder Nickel-Eisenlegierung, bei welchem der Leitungsabschnitt reduzierter Breite eine Breite hat, die im wesentlichen so klein wie möglich ist, wie es durch Stanzen von Metall hergestellt werden kann.

4. Leitungsrahmen nach Anspruch 1, 2 oder 3, bei dem jede Leitung von einer Vielzahl (51a, 52a; 53a, 54a; 55a, 56a; 57a, 58a; 51b, 52b; 53b, 54b; 55b, 56b; 57b, 58b), zwischen dem äußeren Rahmen (11a, 12a, 61a, 62a; 11b, 12b, 61b, 62b) und der Bühne (3a, 3b) einen Abschnitt hat, der sich parallel zu dem Rand der Bühne erstreckt, so daß jene randparallelen Abschnitte längsseitig nebeneinander zwischen dem äußeren Rahmen und der Bühne angeordnet sind, wobei der genannte Leitungsabschnitt reduzierter Breite derjenige von jenen randparallelen Abschnitten ist, der dem äußeren Rahmen am nächsten ist.

5. Leitungsrahmen nach Anspruch 1, 2, 3 oder 4, bei dem mehr als eine der Leitungen (51a, 53a 55a, 57a; 51b, 53b, 55b, 57b) solch einen Leitungsabschnitt reduzierter Breite hat, in Bezug auf die Tragstangen (100a, 101a, 102a, 103a; 100b, 101b, 102b, 103b), die die Tragverbindungen zu dem außeren Rahmen (11a, 12a, 61a, 62a; 11b, 12b, 61b, 62b) für jene Teile bilden.

6. Leitungsrahmen nach Anspruch 5, in Verbindung mit Anspruch 4, bei dem vier solche Vielzahlen von Leitungen (51a, 52a; 53a, 54a; 55a, 56a; 57a, 58a; 51b, 52b; 53b, 54b; 55b, 56b; 57b, 58b) vorgesehen sind, wobei eine Leitung (51a; 53a; 55a; 57a; 51b; 53b; 55b; 57b) in jeder Vielzahl solch einen Abschnitt reduzierter Breite hat, die randparallelen Abschnitte der Leitungen von entsprechend verschiedenen Vielzahlen entweder zwischen verschiedenen Rändern der Bühne (3a; 3b) und dem äußeren Rahmen (11a, 12a, 61a, 62a; 11b, 12b, 61b, 62b) liegen, oder sich in entgegengesetzte Richtungen längs demselben Rand der Bühne erstrecken.

7. Leitungsrahmen nach Anspruch 5, bei dem die Bühne rechtwinklig ist, mit vier Vielzahlen von Leitungen (51b, 52b; 53b, 54b; 55b, 56b; 57b, 58b), die an zwei entgegengesetzten Seiten der Bühne (3b) angeordnet sind, wobei zusätzliche Leitungen (51c bis 58c) an den anderen beiden entgegengesetzten Seiten der Bühne angeordnet sind.

8. Leitungsrahmen nach einem der vorhergehenden Ansprüche, bei dem die oder jede der Tragstangen (100a, 101a, 102a, 103a; 100b, 101b, 102b, 103b) sich senkrecht zu dem Leitungsabschnitt reduzierter Breite erstreckt, für welchen sie eine Tragverbindung zu dem äußeren Rahmen bildet.

9. Leitungsrahmen nach einem der vorhergehenden Ansprüche, bei dem die oder jede Tragstange (100a, 101a, 102a, 103a; 100b, 101b, 102b, 103b) durch zwei Arme oder Brücken gebildet ist, welche den relevanten Leitungsabschnitt reduzierter Breite mit dem äußeren Rahmen verbinden, mit einem Spalt zwischen den beiden Arme oder Brücken.

10. Leitungsrahmen nach einem der vorhergehenden Ansprüche, bei dem der äußere Rahmen seitliche Stangen (11a, 12a; 11b, 12b) und Verbindungsstangen (61a, 62a; 61b, 62b) hat, eine Bühnenstange (41a, 42a; 41b, 42b) vorgesehen ist, um die Bühne (3a, 3b) mit dem äußeren Rahmen zu verbinden, und jeweilige Gruppen der Leitungen mit entsprechenden Verbindungsstangen verbunden sind.

11. Leitungsrahmen nach Anspruch 10, bei dem der äußere Rahmen zwei seitliche Stangen (11a, 12a; 11b, 12b) und zwei Verbindungsstangen (61a, 62a; 61b, 62b) hat, die einen rechtwinkligen Rahmen bilden, und die Bühnenstange (41a, 42a; 41b, 42b) entweder mit den Verbindungsstangen oder mit den seitlichen Stangen verbunden ist.

12. Leitungsrahmen nach Anspruch 10 oder 11, bei dem ein Teil der Bühnenstange (41a, 42a; 41b, 42b), welche der Bühne benachbart ist, aus zwei Armen oder Brücken mit einem Spalt dazwischen gebildet ist.

13. Verpackte Halbleitervorrichtung, mit einem Leitungsrahmen nach einem der vorhergehenden Ansprüche, einem Halbleiterelement, das auf der Bühne montiert ist, und einem Gehäuse, welches das Element einkapselt, wobei die Bühne und Abschnitte der Leitungen, der oder jeder Leitungsabschnitt reduzierter Breite und ein Teil der Länge der entsprechenden Stützstange innerhalb des Gehäuses eingekapselt sind.

## Revendications

1. Cadre de connexion, destiné au montage d'un élément semi-conducteur, comportant un plateau (3a; 3b) destiné au montage de l'élément semi-conducteur, des fils de connexion (51a à 57a; 51b à 58c) placés autour du plateau (3a; 3b), et un cadre externe (11a, 12a, 61a, 62a; 11b, 12b, 61b, 62b) supportant les fils, l'un au moins des fils (51a, 53a, 55a, 57a; 51b, 53b, 55b, 57b) a une partie placée entre le cadre externe et le plateau (3a; 3b) disposée le long du bord du plateau, ayant une épaisseur réduite par rapport aux autres parties de fils, et le cadre de connexion a une barre de support (100a, 101a, 102a, 103a; 100b, 101b, 102b, 103b) qui établit une connexion de support de la partie de fil de connexion de largeur réduite sur le cadre externe.

2. Cadre de connexion selon la revendication 1, dans lequel la partie de fil de connexion de largeur réduite a une largeur pratiquement aussi faible que possible compte tenu de la technologie de fabrication utilisée pour le cadre de connexion.

3. Cadre de connexion selon la revendication 1 ou 2, formé par poinçonnage de métal, par exemple d'un alliage de cuivre ou un alliage fer-nickel, dans lequel la partie de fil de largeur réduite a une largeur pratiquement aussi faible que le permet le poinçonnage du métal.

4. Cadre de connexion selon la revendication 1, 2 ou 3, dans lequel chaque fil de connexion d'un ensemble de fils (51a, 52a; 53a, 54a; 55a, 56a; 57a, 58a; 51b, 52b; 53b, 54b; 55b, 56b; 57b, 58b) comporte, entre le cadre externe (11a, 12a, 61a, 62a; 11b, 12b, 61b, 62b) et le plateau (3a, 3b), une partie qui est disposée parallèlement à un bord du plateau, si bien que les parties parallèles à un bord sont disposées les unes le long des autres entre le cadre externe et le plateau, la partie de fil de connexion de largeur réduite étant celle des parties parallèles au bord qui est la plus proche du cadre externe.

5. Cadre de connexion selon la revendication 1, 2, 3 ou 4, dans lequel plusieurs fils de connexion (51a, 53a, 55a, 57a; 51b, 53b, 55b, 57b) ont une telle partie de fil de largeur réduite, avec des barres respectives de support (100a, 101a, 102a, 103a; 100b, 101b, 102b, 103b) qui établissent des connexions de support de ces parties sur le cadre externe (11a, 12a, 61a, 62a; 11b, 12b, 61b, 62b).

6. Cadre de connexion selon la revendication 5, dépendant de la revendication 4, dans lequel il existe quatre ensembles de fils (51a, 52a; 53a, 54a; 55a, 56a; 57a, 58a; 51b, 52b; 53b, 54b; 55b, 56b; 57b, 58b), un fil (51a; 53a; 55a; 57a; 51b; 53b; 55b; 57b) de chaque ensemble ayant une telle partie de largeur réduite, les parties de fils parallèles aux bords des ensembles différents respectifs étant soit disposées entre des bords différents du plateau (3a; 3b) et le cadre externe (11a, 12a, 61a, 62a; 11b, 12b, 61b, 62b), soit en sens opposés le long du même bord du plateau.

7. Cadre de connexion selon la revendication 5, dans lequel le plateau est rectangulaire, les quatre ensembles de fils (51b, 52b; 53b, 54b; 55b, 56b; 57b, 58b) étant placés sur deux côtés opposés du plateau (3b), des fils supplémentaires (51c à 58c) étant placés sur les deux autres côtés opposés du plateau.

8. Cadre de connexion selon l'une quelconque des revendications précédentes, dans lequel la barre ou chaque barre de support (100a, 101a, 102a, 103a; 100b, 101b, 102b, 103b) est disposée perpendiculairement à la partie de fil de largeur réduite pour laquelle une connexion de support sur le cadre externe est établie.

9. Cadre de connexion selon l'une quelconque des revendications précédentes, dans laquelle la barre de support ou chaque barre de support (100a, 101a, 102a, 103a; 100b, 101b; 102b, 103b) est constituée par deux dérivations ou pontets reliant la partie correspondante de fil de largeur réduite au cadre externe, avec un espace placé entre les deux dérivations ou pontets.

10. Cadre de connexion selon l'une quelconque des revendications précédentes, dans lequel le cadre externe comporte des barres latérales (11a, 12a; 11b, 12b) et des barres de traverse (61a, 62a; 61b, 62b), une barre de plateau (41a, 42a; 41b, 42b) étant disposée afin qu'elle relie le plateau (3a; 3b) au cadre externe, des groupes respectifs de fils de connexion étant connectés les uns aux autres par des barres respectives de traverse.

11. Cadre de connexion selon la revendication 10, dans lequel le cadre externe a deux barres latérales (11a, 12a; 11b, 12b) et deux barres de traverse (61a, 62a; 61b, 62b) formant un cadre rectangulaire, et la barre de plateau (41a, 42a; 41b, 42b) est connectée soit aux barres de traverse, soit aux barres latérales.

12. Cadre de connexion selon la revendication 10 ou 11, dans lequel une partie de la barre de plateau (41a, 42a; 41b, 42b) voisine au plateau est constituée par deux dérivations ou pontets, avec un espace entre eux.

13. Dispositif à semi-conducteur conditionné, comprenant un cadre de connexion selon l'une quelconque des revendication précédentes, un élément semi-conducteur monté sur le plateau et un boîtier enrobant l'élément, le plateau et les parties de fils de connexion, la partie de fil de largeur réduite ou chaque partie de fil de largeur réduite et la partie de longueur de la barre correspondante de support étant enrobées dans le boîtier.

Fig. 1

EP 0 118 237 B1

Fig. 2

Fig. 3

EP 0 118 237 B1

3

# Fig. 4

Fig. 5

5

Fig. 6

(a)

101b 53b 54b 41b 52b 51b 100b

55c
56c
57c
58c

51c
52c
53c
54c

103b 57b 58b 42b 56b 55b 102b

(b)

58c

54c

103b 57b 58b 42b 56b 55b 102b

(c)

101b 53b 54b 41b 52b 51b 100b

55c
56c
57c
58c

51c
52c
53c
54c

103b 57b 58b 42b 56b 55b 102b